(19) **Europäisches Patentamt**
**European Patent Office**
**Office européen des brevets**

(11) **EP 2 657 365 B1**

(12) **EUROPEAN PATENT SPECIFICATION**

(45) Date of publication and mention
of the grant of the patent:
**18.01.2017 Bulletin 2017/03**

(51) Int Cl.:
*C23C 16/56* (2006.01)    *H01L 21/316* (2006.01)
*C23C 16/40* (2006.01)    *C23C 16/30* (2006.01)
*H01L 21/02* (2006.01)    *H01L 21/3105* (2006.01)
*B32B 5/18* (2006.01)

(21) Application number: **13177963.9**

(22) Date of filing: **08.12.2009**

(54) **Method for removal of carbon from an organosilicate material**

Verfahren zur Entfernung von Kohlenstoff aus einem Organosilikatmaterial

Procédé de suppression du carbone dans un matériau d'organosolicate

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **11.12.2008 US 121666 P**
**08.10.2009 US 575772**

(43) Date of publication of application:
**30.10.2013 Bulletin 2013/44**

(62) Document number(s) of the earlier application(s) in accordance with Art. 76 EPC:
**09178272.2 / 2 199 428**

(73) Proprietor: **AIR PRODUCTS AND CHEMICALS, INC.**
**Allentown, PA 18195-1501 (US)**

(72) Inventors:
• **Wu, Aiping**
 **Macungie, PA Pennsylvania 18062 (US)**
• **Weigel, Scott Jeffrey**
 **Allentown, PA Pennsylvania 18104 (US)**
• **Braymer, Thomas Albert**
 **Allentown, PA Pennsylvania 18103 (US)**

(74) Representative: **Andrae | Westendorp**
**Patentanwälte Partnerschaft**
**Uhlandstraße 2**
**80336 München (DE)**

(56) References cited:
**EP-A1- 1 354 980**     **EP-A2- 1 873 818**
**JP-A- 2001 196 348**     **US-A1- 2002 139 387**
**US-A1- 2006 078 676**     **US-A1- 2008 119 058**
**US-B1- 7 265 061**

• **HOZUMI A ET AL: "LOW-TEMPERATURE ELIMINATION OF ORGANIC COMPONENTS FROM MESOSTRUCTURED ORGANIC-INORGANIC COMPOSITE FILMS USING VACUUM ULTRAVIOLET LIGHT", CHEMISTRY OF MATERIALS, AMERICAN CHEMICAL SOCIETY, WASHINGTON, US, vol. 12, 1 January 2000 (2000-01-01), pages 3842-3847, XP008060695, ISSN: 0897-4756, DOI: 10.1021/CM000546K**
• **CORNEC CH L ET AL: "K value improvement of ULK dielectrics by wet activation", MICROELECTRONIC ENGINEERING, ELSEVIER PUBLISHERS BV., AMSTERDAM, NL, vol. 83, no. 11-12, 1 November 2006 (2006-11-01), pages 2122-2125, XP024954751, ISSN: 0167-9317, DOI: 10.1016/J.MEE.2006.09.017 [retrieved on 2006-11-01]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

CROSS-REFERENCE TO RELATED APPLICATIONS

This application claims the benefit of U.S. Provisional Application No. 61/121,666, filed 11 December 2008.

BACKGROUND OF THE INVENTION

Described herein is a method for removing certain carbon species within organosilicate (OSG) materials or films. More specifically, described herein is a method for selectively removing at least a portion of the carbon-containing species such as, but not limited to, non-network carbon, carbon-containing residues from processing steps, and/or Si-$CH_2$-Si bridge groups that are contained within porous, low dielectric constant OSG materials or films while retaining a majority of the methyl groups covalently bonded to Si atoms which are referred to herein as network-terminating carbon groups. By removing at least a portion of the carbon-containing species, it is believed that at least one of the following properties, dielectric constant, mechanical strength, refractive index, or combinations thereof, of the OSG materials or films can be improved when compared to OSG materials or films that do not have the carbon-containing species removed.

The electronics industry uses dielectric materials as insulating layers between circuits and components of integrated circuits (IC) and associated electronic devices. Line dimensions are being reduced in order to increase the speed and memory storage capability of microelectronic devices (e.g., computer chips). As the line dimensions decrease, the insulating requirements for the interlayer dielectric (ILD) become much more rigorous. Shrinking the spacing requires a lower dielectric constant to minimize the RC time constant, where R is the resistance of the conductive line and C is the capacitance of the insulating dielectric interlayer. C is inversely proportional to spacing and proportional to the dielectric constant (k) of the interlayer dielectric (ILD). Conventional silica ($SiO_2$) CVD dielectric films produced from $SiH_4$ or TEOS ($Si(OCH_2CH_3)_4$, tetraethylorthosilicate) and $O_2$ have a dielectric constant (k) of 4.0.

There are several ways in which industry has attempted to produce silicate-based CVD films with lower dielectric constants. One effective way to produce a lower dielectric constant film has been to dope a silicon oxide film with organic groups. The resultant film may have a dielectric constant that ranges from 2.7 to 3.5. These doped films, referred to herein as organosilicate ("OSG") films, are typically deposited as a dense film (density ~ 1.5 g/cm$^3$) from an organosilicon precursor and an oxidant.

OSG films may be deposited by a chemical vapor deposition (CVD) process. In a typical CVD process, precursor gases are flowed into a reaction chamber, activated, and a material is deposited on a substrate inside the chamber. The activation of the precursors may occur by using an energy source such as, for example, a thermal or a RF-coupled plasma source. The chemical vapor deposition of an OSG material can be accomplished using a variety of precursors. Examples of commonly used precursors are organosilanes containing methyl groups are tetramethylsilane, dimethyldimethoxysilane, diethoxymethylsilane, octamethylcyclotetrasiloxane, and/or tetramethylcyclotetrasiloxane. Plasma-enhanced chemical vapor deposition (PECVD) is the most commonly used CVD process to react methyl-containing organosilanes to form OSG materials. OSG films produced by PECVD processes typically contain from 10 to 40% atomic carbon and dielectric constants that range from 2.7 to 3.2, although lower dielectric constant values can be achieved if the film is made porous. As industry demands for films having dielectric constant values below 2.7 due to higher device densities and smaller dimensions have increased, the industry has turned to various porous materials for improved insulating properties.

The implementation of OSG materials as ILD's in IC's has hit several stumbling blocks. One major hurdle is the reduced mechanical properties of the porous OSG materials over traditional silica ($SiO_2$) materials. Mechanical properties of an ILD are typically reported by nanoindentation in gigapascals (GPa) as hardness (H) or Young's modulus. The hardness is a measure of the applied force required to indent the film whereas Young's modulus is the elastic response of the material to the applied force or compression. Silica has a hardness that may range from 8 to 10 GPa. By contrast, an OSG material has a hardness that may range from 0.1 to 5 GPa, depending on the dielectric constant and the process conditions at which the material was deposited. Mechanical strength is needed for subsequent processing steps such as etching, chemical mechanical planarization ("CMP") processing, and depositing additional layers such as diffusion barriers for copper, copper metal ("Cu"), and cap layers on the product. In some of these processes, temperature cycling of multiple layers may induce stresses due to the coefficient of thermal expansion mismatch between the different materials thereby causing cracking or delamination. Surface planarity is also required and may be maintained through controlling processing parameters such as those during the film formation process and through CMP. Mechanical integrity, stiffness, compressive, and shear strengths may be particularly important to survive CMP. These mechanical properties are also important in the packaging of the final product.

Since the dielectric constant of air is nominally 1.0, yet another approach to reducing the dielectric constant of a material may be to introduce porosity or reducing the density of the material. A dielectric film when made porous may exhibit lower dielectric constants compared to a relatively denser film.

Porosity has been introduced in low dielectric materials through a variety of different means. For example, porosity may be introduced by decomposing part of the film resulting in a film having an increased porosity and a lower density.

A method used extensively in the literature for introducing porosity into a film is thermal annealing to decompose at least a portion of the film thereby creating pores and ultimately lowering the dielectric constant. Yet another method of introducing porosity into the film by removing at least a portion of the porogen contained therein is through exposing the film to an ultraviolet (UV) light source. In the annealing step, or curing step, the film is typically heated and/or exposed to a UV light source to decompose and/or remove volatile components and substantially cross-link the film. U.S. Patent No. 6,312,793 describes a multiphasic material having a first phase consisting essentially of Si, C, O, and H, a second phase consisting essentially of C and H, and a multiplicity of pores. The material is heated to a temperature of at least 300°C and for a time of at least 15 minutes to induce removal of one of the phases. Published Patent Application WO 00/02241 describes heating an alkoxysilane material at a temperature from 100 to 400°C for a time of 1 to 10 minutes to induce formation of pores by removing the solvent contained therein. Published Patent Application WO 02/07191A2 describes heating a silica zeolite thin film to a temperature range of 350 to 550°C for an unspecified amount of time to induce adsorbed material to leave the zeolitic framework thereby lowering the dielectric constant.

US 2006/0078676 A1 relates to a porous organosilicate glass (OSG) film: $Si_vO_wC_xH_yF_z$, where v+w+x+v+z=100%, v is 10 to 35 atomic %, w is 10 to 65 atomic %, x is 5 to 30 atomic %, y is 10 to 50 atomic % and z is 0 to 15 atomic %, has a silicate network with carbon bonds as methyl groups ($Si-CH_3$) and contains pores with diameter less than 3 nm equivalent spherical diameter and dielectric constant less than 2.7. A preliminary film is deposited by a chemical vapor deposition method from organosilane and/or organosiloxane precursors, and independent pore-forming precursors. Porogen precursors form pores within the Preliminary film and are subsequently removed to provide the porous film. Compositions, film forming kits, include organosilane and/or organosiloxane compounds containing at least one Si-H bond and porogen precursors of hydrocarbons containing alcohol, ether, carbonyl, carboxylic acid, ester, nitro, primary amine, secondary amine, and/or tertiary amine functionality or combinations.

The amount of organic or carbon-containing groups chemically incorporated into the material affects both the dielectric constant and the mechanical strength. The as-deposited film contains a combination of network carbon-containing groups and non-network carbon-containing groups. Mechanical strength reduction observed for OSG films, when compared to a $SiO_2$ film that does not contain organic groups, may be partially attributed to the disruption in the silica network by the introduction of terminal organic groups, particularly methyl groups bonded to a silicon, atom. One way of describing the network disruption is by using the ratio of the number of carbon atoms in the film to the number of silicon atoms in the film and which is referred to herein as the C/Si ratio. It is believed that the more organic groups that are contained within the film, the less silicon atoms that are bonded to four other silicon through oxygen bridges which may lower the corresponding hardness. However, if there are too few organic groups within the film, the dielectric constant may be adversely affected. As a result, the benefit of adding organic groups to lower the dielectric constant may diminish with increasing amounts of organic groups within the film due to its decreased hardness.

Accordingly, there is a need in the art to provide an improved method to produce low density and porous OSG materials. Therefore, there is a need in the art for a cleaning composition that effectively removes at least a portion of the carbon-containing species contained within the porous organosilicate film thereby improving at least the mechanical strength of the film without adversely impacting the dielectric constant of the film.

BRIEF SUMMARY OF THE INVENTION

Described herein is a method for removing at least a portion of the carbon-containing species within an organosilicate (OSG) film by a method according to claim 1. In one aspect, there is provided a method for forming a porous organosilicate film comprising: providing a composite organosilicate film wherein the composite organosilicate film is deposited from a composition comprising at least one silicon-containing precursor and at least one porogen precursor and wherein the composite organosilicate film comprises carbon-containing species; exposing the composite organosilicate film to an energy source comprising ultraviolet light; and treating the composite organosilicate film to a chemical comprising an oxidizer to remove at least a portion of the carbon-containing species contained therein, exposing the porous organosilicate film to an energy source comprising ultraviolet light to remove at least a portion of the carbon-containing species contained therein and provide a porous organosilicate film according to the method of claim 1.

In another aspect, there is provided a method for forming a porous organosilicate film comprising: forming via vapor deposition a composite organosilicate film from a composition comprising at least one silicon-containing precursor and at least one porogen precursor wherein the composite organosilicate film comprises carbon-containing species; treating the composite organosilicate film to a chemical to remove at least a portion of the carbon-containing species contained therein; and exposing the porous organosilicate film to an energy source comprising ultraviolet light to remove at least a portion of the carbon-containing species contained therein and provide the porous organosilicate film.

In a further aspect, there is provided a method for forming a porous organosilicate film comprising: providing a composite organosilicate film wherein the composite organosilicate film comprises carbon-containing species, a first dielectric constant, and a first hardness; treating the composite organosilicate film to a chemical comprising an oxidizer to remove at least a portion of the carbon-containing species therein; and exposing the composite organosilicate film to an energy source comprising ultraviolet light and optionally thermal energy to remove at least a portion of the carbon-containing species therein and provide the porous organosilicate film comprising a second dielectric constant and a second hardness wherein the second dielectric constant is substantially the same as or less than the first dielectric constant and wherein the second hardness is greater than the first hardness.

DETAILED DESCRIPTION OF THE INVENTION

Described herein is a method for removing at least a portion of the carbon-containing species within an OSG film by the method according to claim 1. The method described herein selectively removes at least a portion of the carbon-containing species from the OSG film while retaining a majority of the methyl groups covalently bonded to Si atoms which are referred to herein as network-terminating carbon groups. The term "carbon-containing species" as used herein describes certain species that are present within the OSG film, which can be at least a portion of the porogen precursor contained therein; carbon-containing residues from various processing steps such as, but not limited to, depositing the film (e.g., precursor residue from one or more precursors used to form the composite film), curing the film, etching the film, ashing the film, and combinations thereof; non-network carbon species; and/or certain network carbon groups such as $Si-CH_2-Si$ bridge groups. The selective removal of these carbon-containing species by the method described herein may be seen, for example, through Fourier transform infrared spectroscopy (FTIR), X-ray photoelectron spectroscopy (XPS), Raman spectroscopy, nuclear magnetic resonance (NMR), or other analytical techniques. It is believed that by selectively removing at least a portion of the carbon-containing species within the composite or porous OSG, the dielectric constant of the porous OSG film can be maintained or reduced while improving the mechanical properties of the porous film. This is surprising and unexpected because it was believed that treatment of the composite or the porous OSG with certain chemicals may adversely affect the mechanical properties and the network-terminating carbon groups of the porous film.

In certain embodiments, the treating and/or exposing steps are performed on a composite OSG film. In this or other embodiments, the treating and/or exposing steps are performed on a porous OSG film. The term "composite organosilicate film" as used herein describes an OSG film that was deposited from a composition comprising at least one structure-former precursor, at least one porogen precursor, and contains carbon-containing species. The term "porous organosilicate film" as used herein describes an OSG film comprising pores. In certain embodiments, the porous OSG film is provided by removing at least a portion of the porogen precursor contained within the composite OSG film. At least a portion of the porogen precursor may be removed, for example, by a thermal anneal or cure, a ultraviolet anneal or cure, a combination of thermal and ultraviolet anneal or cure, or any other method that is available to one or skill in the art for removing at least a portion of the pore-former precursor contained within the composite OSG film. The cure step or steps provides pores within the film by removing components of the porogen precursor from the as-deposited film.

In certain embodiments depending upon the composition of the composite film, it appears that some carbon-containing species are left in the pore system after the one or more cure steps are completed. In this or other embodiments, it may appear that the presence of the carbon-containing species within the film may be beneficial by protecting the OSG network of the film from damage during subsequent processing steps such as, for example, etching and ashing. However, the presence of carbon-containing species may also increase the dielectric constant of the film, by incorporating species that contribute to the electronic, ionic, or configurational components of the dielectric constant, thereby requiring additional porosity to be introduced to the film to achieve the desired dielectric constant. As the porosity of the film increases, an undesirable decrease in the mechanical properties of the film may result. It is believed that if at least a portion of the unwanted carbon-containing species could be selectively removed from the film rather than the network-terminating carbon groups (i.e., the $Si-CH_3$ that introduces hydrophobicity to the film), it may be possible to improve film properties, such as but not limited to, dielectric constant and mechanical strength when compared to similar films that contain the unwanted carbon-containing species.

The treating

The method described herein is suitable for a low dielectric constant (i.e., 4.0 or less) organosilicate glass (OSG) material and films comprising same. In certain embodiments, the low dielectric constant material or film is formed by the chemical vapor deposition of a structure-forming precursor, such as one or more silica-containing precursor, and one or more porogen precursors. A "porogen", as used herein, is a reagent that is used to generate void volume within the resultant material or film. During the deposition process, the silicon-containing and porogen precursors are chemically activated and co-deposit on a substrate surface to form a composite organosilicate material. As a result of the chemical activation, the porogen precursor will polymerize to form a species of higher molecular weight than the precursor itself. The term "polymerize", as used herein, refers to a process in which the polymer is formed by the reaction/combination of these ions, radicals and fragments after the monomers or oligomers of the precursors are ionized and fragmented by the plasma and/or other energy source as well as processes in which the polymer is formed by the repetitive addition of monomer units in a regimented or random order. After deposition, the porogen can be removed from the composite organosilicate material by the introduction of an energy source such as, but not limited to, thermal treatments, photon energy including but not limited to ultraviolet light, electron beam or e-beam, plasmas, x-rays, and combinations thereof. The removal of at least a portion of the porogen results in a porous OSG material.

As previously mentioned, the porous OSG material is deposited using at least one silicon-containing precursor and at least one porogon precursor. Examples of silicon-containing precursors that can be used to provide the porous OSG material may include, but are not limited to, triethoxysilane, tritertbutoxysilane, trimethyoxysilane, tri(tertiary)butoxysilane, triacetoxysilane, tetra(tertiary)butoxysilane, tetraethoxysilane, tetramethoxysilane, tetraacetoxysilane, diethoxymethylsilane, dimethoxymethylsilane, ditertbutoxymethylsilane, methyltriacetatoxysilane, dimethylacetatoxysilane, dimethyldiacetoxysilane, dimethyldimethoxysilane, dimethyldiethoxysilane, methyltriethoxysilane, neohexyltriethoxysilane, neopentyltrimethoxysilane, diacetoxymethylsilane, phenyldimethoxysilane, phenyldiethoxysilane, phenyltriethoxysilane, phenyltrimethoxysilane, phenylmethyldimethoxysilane, 1,3,5,7-tetramethyltetracyclosiloxane, octamethyltetracyclosiloxane, 1,1,3,3-tetramethyldisiloxane, 1-neohexyl-1,3,5,7-tetramethylcyclotetrasiloxane, hexamethyldisiloxane, 1,3-dimethyl-1-acetoxy-3-ethoxydisiloxane, 1,2-dimethyl-1,2-diacetoxy-1,2-diethoxydisilane, 1,3-dimethyl-1,3-diethoxydisiloxane, 1,3-dimethyl-1,3-diacetoxydisiloxane, 1,2-dimethyl,1,1,2,2-tetraacetoxydisilane, 1,2-dimethyl-1,1,2,2-tetraethoxydisilane, 1,3-dimethyl-1-acetoxy-3-ethoxydisiloxane,1,2-dimethyl-1-acetoxy-2-ethoxydisilane, methylacetoxy-t-butoxysilane, methylsilane, dimethylsilane, trimethylsilane, tetramethylsilane, hexamethyldisilane, tetramethyldisilane, dimethyldisilane, and combinations thereof. Further examples of silicon-containing precursors are provided, for example, in U. S. Pat. Nos. 7,122,880, 6,818,289, 6,896,955, 7,265,062, 6,312,793, 6,441,491, 6,479,110, 7,282,458, 7 288,292, and 7,312,524. Examples of the least one porogen precursor include, but are not limited to, alpha-terpinene, limonene, cyclohexane, cyclooctane, bicyclohexadiene (BCHD), gamma-terpinene, camphene, dimethylhexadiene, ethylbenzene, norbonadiene, cyclopentene oxide, 1,2,4-trimethylcyclohexane, 1,5-dimethyl-1,5-cyclooctadiene, camphene, adamantane, 1,3-butadiene, substituted dienes, decahydronaphthelene, and combinations thereof. In one embodiment, the at least one porogen precursor is a gaseous hydrocarbon having from 1 to 13 carbon atoms. Further examples of porogen precursors are provided, for example, in U. S. Pat. Nos. 6,846,515, 7,384,471, 6,312,793, 6,441,491, 6,479,110, 7,282,458, 7,288,292, and 7,312,524.

The organosilicate films are deposited onto at least a portion of a substrate from the precursor mixture using a variety of different methods. These methods may be used by themselves or in combination. Some examples of processes that may be used to form the organosilicate film include but are not limited to the following: thermal chemical vapor deposition, plasma enhanced chemical vapor deposition ("PECVD"), high density PECVD, photon assisted CVD, plasma-photon assisted ("PPECVD"), cryogenic chemical vapor deposition, chemical assisted vapor deposition, hot-filament chemical vapor deposition, photo initiated chemical vapor deposition, CVD of a liquid polymer precursor, deposition from supercritical fluids, or transport polymerization ("TP"). U. S. Pat. Nos. 6,171,945, 6,054,206, 6,054,379, 6,159,871 and WO 99/41423 provide some exemplary CVD methods that may be used to form the organosilicate film described herein. In certain embodiments, the deposition is conducted at a temperature ranging from 100 to 425°C, or from 200 to 425°C, or from 200 to 400°C. Although the chemical reagents used herein may be sometimes described as "gaseous", it is understood that the chemical reagents may be delivered directly as a gas to the reactor, delivered as a vaporized liquid, direct liquid injection, a sublimed solid and/or transported by an inert carrier gas into the reactor.

In certain embodiments, the organosilicate film is formed through a plasma-enhanced chemical vapor deposition process. Briefly in a PECVD process, chemical reagents are flowed into a reaction chamber such as a vacuum chamber and plasma energy energizes the chemical reagents thereby forming a film on at least a portion of the substrate. In these embodiments, the organosilicate film can be formed by the co-deposition, or alternatively the sequential deposition, of a gaseous mixture comprising at least one silicon containing precursor and at least one porogen precursor. In certain embodiments, the plasma energy applied to the reagents may range from 0.02 to 7 watts/cm$^2$, or from 0.3 to 3 watts/cm$^2$. Flow rates for each of the reagents may range from 10 to 5000, or from 100 to 1,000, or from 100 to 500 standard cubic centimeters per minute (sccm$^{-1}$). In these embodiments, the PECVD may be conducted using a capacitively coupled plasma at a frequency of 13.56 MHz. Pressure values in the vacuum chamber during deposition for a PECVD process may range from 1.333 Pa to 79993.421 Pa (0.01 to 600 torr), or from 133.322 Pa to 13333.224 Pa (1 to 10 torr). In certain embodiments, the deposition is conducted at a temperature ranging from 100 to 425°C, or from 200 to 425°C. In these or other embodiments, a carrier gas is employed in the deposition process, which possesses a low ionization energy to lower the electron temperature in the plasma, which in turn will cause less fragmentation of the silicon-containing precursor(s) within the mixture. Examples of low ionization energy carrier gases include $CO_2$, $NH_3$, CO, $CH_4$, Ar, Xe, Kr. It is understood however that process parameters such as plasma energy, flow rate, and pressure may vary depending upon numerous factors such as the surface area of the substrate, the precursors used in the deposition process, the equipment used in the PECVD process, etc.

Energy is applied to the precursor mixture to induce reaction and to form the composite OSG film on the substrate. Such energy can be provided by, but not limited to, thermal, plasma, pulsed plasma, helicon plasma, high density plasma, inductively coupled plasma, X-ray, e-beam, photon, and remote plasma methods. In certain embodiments, a secondary RF frequency source can be used to modify the plasma characteristics at the substrate surface.

In other embodiments of the method described herein, the composite film may be deposited onto at least a portion of a substrate by a spin-on deposition process. Examples of these deposition processes are provided, for example, in U. S. Pat. Nos. 7,122,880, 6,818,289, 6,896,955, and 7,265,062.

As previously mentioned, the method described herein removes at least a portion of the carbon-containing species within an organosilicate (OSG) film by treating the film according to claims 1 with a chemical, such as, but not limited to, an oxidizer, exposing the film to an energy source, such as, but not limited to, ultraviolet light, or a combination of treating the film with a chemical and exposing the film to an energy source according to claim 1. The method may be used on a composite film, a porous film, or both the composite and porous film. In certain embodiments, at least one porogen precursor is removed from the as-deposited or composite film by a curing step, which can comprise thermal annealing, chemical treatment, in-situ or remote plasma treating, photocuring and/or microwaving. Other in-situ or post-deposition treatments may be used to enhance materials properties like hardness, stability (to shrinkage, to air exposure, to etching, to wet etching, to wet cleans, to ashing, to CMP processes, etc.), integrability, uniformity and adhesion. Such treatments can be applied to the composite OSG film prior to, during and/or after porogen removal using the same or different means used for porogen removal. The conditions under which these treatments are conducted can vary greatly. For example, these treatments can be conducted under high pressure, under a vacuum, at ambient conditions, or variations thereof.

In certain embodiments, the composite OSG film is subjected to an annealing or cure step to remove at least a portion of the porogen precursor contained therein and provide a porous film. In these embodiments, the annealing step is conducted under the following conditions. The environment can be inert (e.g., nitrogen, $CO_2$, noble gases (He, Ar, Ne, Kr, Xe), etc.), oxidizing (e.g., oxygen, air, dilute oxygen environments, enriched oxygen environments, ozone, nitrous oxide, etc.) or reducing (dilute or concentrated hydrogen, hydrocarbons (saturated, unsaturated, linear or branched, aromatics), etc.). The pressure may range from about 133.322 Pa to about 133322.368 Pa (from about 1 Torr to about 1000 Torr), or atmospheric pressure. However, a vacuum ambient is also possible for thermal annealing as well as any other post-curing means. The temperature may range from 200-500 °C. The temperature ramp rate may range from 0.1 to 100 °C/min. The temperature may range from ambient temperature (e.g., 25°C) to 500°C. The pressure may range from 1.333 Pa (10 mtorr) to atmospheric pressure. The total curing time may range from 0.01 min to 12 hours.

As previously mentioned, the method described herein may improve at least the mechanical strength of the composite film, the porous film, or both by selectively removing at least a portion of the carbon-containing species containing in the composite or porous film according to claim 1. The method may also restore or reduce the dielectric constant of the porous OSG film. In certain embodiments, the composite or porous OSG film is subjected to one or more chemical treatments. The term "chemical treatment" generally relates to exposing the film to one or more chemicals or chemical compositions. Chemicals used in such treatments can be in a variety of fluid states such as sublimed solids, vapors, liquids, gases, aerosols, supercritical fluid states, or combinations thereof. Examples of chemicals that can be used to treat the OSG film include, but are not limited to, fluorinating chemicals (e.g., HF, $SiF_4$, $NF_3$, $F_2$, $COF_2$, $CO_2F_2$); oxidizing chemicals (e.g., $H_2O_2$, $O_3$, ozonated water ($O_3/H_2O$)); reducing chemicals (e.g., hydrazine, ferrous compounds, hydrides ($LiAlH_4$, $NaBH_4$, diisobutylaluminum hydride), stannous compounds, sulfite compounds, oxalic acid, hydrocarbons, carbon monoxide, hydrogen, hydrogen atoms (e.g., generated from plasmas, remote plasmas, hot filament, or other sources); sulfuric acid peroxide mixture ("SPM"); chemical drying; methylating; or other chemical treatments that enhance the properties of the final material. Still further examples of chemicals that can be used to treat the composite or porous OSG film include but are not limited to, water, alcohols, aldehydes, ketones, esters, amides, glycols, glycol esthers, ethers, epoxides, amines, and mixtures thereof. Specific examples of solvents include cyclohexanone, 2-hexanone, 2-pentanone, 1-pentanol, 1-butanol, 2-propanol, propylene glycol propyl ether, propylene glycol monomethyl -acetate, ethyl lactate, pentyl acetate, propylene glycol, propylene glycol monomethyl ether, N,N-dimethylformamide, and mixtures thereof. In embodiments wherein a solvent is employed, the chemical may comprise additives such as, for example, catalysts, flow aids, wetting agents, pH adjusters, corrosion inhibitors, ionic strength adjusters, and surfactants. Yet other examples of chemicals that can be used to treat the composite or porous OSG film include stripping or cleaning compositions, such as but not limited to, those compositions found in U. S. Pat. Nos.4,770,713, 5,279,771, 5,419,779, 5,417,877, 5,597,420, 5,997,658, 6,677,286, 6,828,289, 6,943,141, 6,943,142, 6,951,710, and U. S. Publ. Nos. 2004/0063042, 2005/0119143, 2006/0014656, 2006/0016785, 2008/0199977, and 2005/0196974, 2006/0003910, and 2007/0299239. According to claim 1 the composite or porous OSG film is treated with a chemical comprising an oxidizer. Exemplary oxidizer chemicals include, but are not limited to, oxygen ($O_2$), ozone ($O_3$), ozonated water ($O_3/H_2O$), SPM, oxygen atoms, radicals of $O_2$ or $O_3$, charged species of $O_2$ or $O_3$, and combinations thereof. Ozonated water may prepared by bubbling gaseous $O_3$ through water. SPM solutions are commonly used in the semiconductor industry to remove organics. These chemicals can be used by themselves or with other chemicals described herein or know in the art. Not intending to be limiting, Table I provides several examples of particular treatment conditions in terms of time, temperature, and pressure for the oxidizers comprising ozone, ozonated water and SPM.

Table I: Exemplary Chemical Treatment Conditions

| | Time | | Temperature | | Pressure | |
|---|---|---|---|---|---|---|
| | Range | Preferred | Range | Preferred | Range | Preferred |
| $O_3$ | 0.1 to 30 min | 1 to 10 min | Ambient to 40°C | Ambient to 30°C | atmosphere | atmosphere |
| $O_3/H_2O$ | 0.1 to 120 min | 1 to 60 min | 20 to 40°C | 20 to 30°C | atmosphere | atmosphere |
| SPM | 0.1 to 60 min | 1 to 30 min | Ambient to 200°C | 100 to 150°C | atmosphere | atmosphere |

Not to be limited by theory, it appears that the chemical comprising an oxidizer reacts with at least a portion of the carbon-containing species contained within the composite or porous film to form additional carbon-containing by-products without breaking the covalently bonded Si-CH$_3$ group or network terminating groups (as evidenced by FTIR and XPS). The additional carbon-containing by-products can either be removed by an additional chemical treatment step, exposure to an energy source, or combinations thereof. In one embodiment of the method described herein, the composite film is exposed to an energy source comprising ultraviolet light to provide a porous film comprising carbon-containing species, the porous film is treated with one or more chemicals comprising an oxidizer to remove at least a portion of the carbon-containing species but forming additional carbon-containing by-products, and the porous film is then treated with an energy source comprising ultraviolet light to the remove the remaining carbon-containing species, the carbon-containing by-products, and/or any defects attributable to the chemical treatment. In another specific embodiment of the method described herein, the composite film is treated with one or more chemicals comprising an oxidizer to remove at least a portion of the carbon-containing species but forming additional carbon-containing by-products and the porous film is then treated with an energy source comprising ultraviolet light to remove the remaining carbon-containing species, the carbon-containing by-products, and/or any defects attributable to the chemical treatment.

In certain embodiments, the composite or porous OSG film is exposed to an energy source comprising ultraviolet light (UV). The term "ultraviolet light" may include, but is not limited to, near UV, middle UV, or combinations thereof. In certain embodiments, the UV light has one or more wavelengths ranging from 10 nanometers (nm) to 400nm. The ultraviolet light may be dispersive, focused, continuous wave, pulsed, or shuttered. Sources for the ultraviolet light include, but are not limited to, an excimer laser, a barrier discharge lamp, a mercury lamp, a microwave-generated UV lamp, a laser such as a frequency doubled or frequency tripled laser in the IR or visible region, or a two-photon absorption from a laser in the visible region. The ultraviolet light source may be placed at a distance that ranges from 1.27 mm to 304.8 m (50 milli-inches to 1,000 feet) from the composite film. The environment can be inert (e.g., nitrogen, CO$_2$, noble gases (He, Ar, Ne, Kr, Xe), etc.), oxidizing (e.g., oxygen, air, dilute oxygen environments, enriched oxygen environments, ozone, nitrous oxide, etc.), reducing (e.g., dilute or concentrated hydrocarbons, hydrogen, etc.), or a combination thereof. The power may range from 0 to 5000 Watts (W) or from 100 to 5000W. The temperature may range from ambient to 500°C, or from 50 to 400°C. The pressure may range from 1.333 Pa (10 mtorr) to atmospheric pressure. The total curing time may range from 0.01 minute to 12 hours or from 0.5 minutes to 60 minutes.

In embodiments wherein the composite or porous OSG film is exposed to an energy source comprising ultraviolet light (UV), the composite or porous OSG film may be exposed to one or more specific wavelengths within the source or a broad spectrum of wavelengths. For example, the composite film may be exposed to one or more particular wavelengths of light such as through a laser and/or optically focused light source. In the latter embodiments, the radiation source may be passed through optics such as lenses (e.g., convex, concave, cylindrical, elliptical, square or parabolic lenses), filters (e.g., RF filter), windows (e.g., glass, plastic, fused silica, synthetic silica, silicate, calcium fluoride, lithium fluoride, or magnesium fluoride windows) or mirrors to provide specific and focused wavelengths of light. In these embodiments, a non-reactive gas may be flowed over the optics during at least a portion of the exposing step to prevent the formation of build-up on the surface of the optics formed by off-gassing during the pore-formation step. Alternatively, the radiation source does not pass through any optics.

Besides ultraviolet light, the composite or porous OSG film may be exposed to one or more additional energy sources including but not limited to thermal energy, α-particles, β-particles, γ-rays, x-rays, electron beam (e-beam), visible light, infrared light, microwave, radio-frequency wavelengths, and combinations thereof.

The exposure step may be conducted in a variety of settings depending upon the process used to form the composite film. It may be advantageous for the exposure step to be conducted after or even during at least a portion of the composite film formation step. The exposure step can be performed in various settings such as, but not limited to, a quartz vessel, a modified deposition chamber, a conveyor belt process system, a hot plate, a vacuum chamber, a cluster tool, a single wafer instrument, a batch processing instrument, or a rotating turnstile.

In certain embodiments, the composite or porous OSG film is subjected to a plasma treatment. In these embodiments, the plasma treating is conducted under the following conditions. The environment can be inert (nitrogen, $CO_2$, noble gases (He, Ar, Ne, Kr, Xe), etc.), oxidizing (e.g., oxygen, air, dilute oxygen environments, enriched oxygen environments, ozone, nitrous oxide, etc.), or reducing (e.g., dilute or concentrated hydrogen, hydrocarbons (saturated, unsaturated, linear or branched, aromatics), etc.). The plasma power may range from 0-5000 W. The temperature may range from ambient to 500°C. The pressure may range from 1.333 Pa (10 mtorr) to atmospheric pressure. The total curing time is may range from 0.01 min to 12 hours.

In certain embodiments, the composite or porous OSG film is subjected to microwave post-treatment. In these embodiments, microwave post-treatment is conducted under the following conditions. The environment can be inert (e.g., nitrogen, $CO_2$, noble gases (He, Ar, Ne, Kr, Xe), etc.), oxidizing (e.g., oxygen, air, dilute oxygen environments, enriched oxygen environments, ozone, nitrous oxide, etc.), or reducing (e.g., dilute or concentrated hydrocarbons, hydrogen, etc.). The temperature may range from ambient to 500°C. The power and wavelengths are varied and tunable to specific bonds. The total curing time may range from 0.01 min to 12 hours.

In certain embodiments, the composite or porous OSG film is subjected to electron beam post-treatment. The use of electron beam treatment may provide for porogen removal and enhancement of film mechanical properties through bond-formation processes in matrix. In these embodiments, electron beam post-treatment is conducted under the following conditions. The environment can be vacuum, inert (e.g., nitrogen, $CO_2$, noble gases (He, Ar, Ne, Kr, Xe), etc.), oxidizing (e.g., oxygen, air, dilute oxygen environments, enriched oxygen environments, ozone, nitrous oxide, etc.), or reducing (e.g., dilute or concentrated hydrocarbons, hydrogen, etc.). The temperature may range from ambient to 500°C. The electron density and energy can be varied and tunable to specific bonds. The total curing time may range from 0.001 min to 12 hours, and may be continuous or pulsed. Examples of certain electron beam treatments are provided in the following: S. Chattopadhyay et al., Journal of Materials Science, 36 (2001) 4323-4330; G. Kloster et al., Proceedings of IITC, June 3-5, 2002, SF, CA; and U.S. Pat. Nos. 6,207,555 B1, 6,204,201 B1 and 6,132,814 A1.

In certain embodiments, the films described herein are porous. In these embodiments, total porosity of the film may be from 5 to 75% depending upon the process conditions and the desired final film properties. The average sizes within the porous film ranges from about 1 Å to about 500 Å, or from about 1 Å to about 100 Å, or from about 1 Å to about 50 Å. It is preferred that the film has pores of a narrow size range and that the pores are homogeneously distributed throughout the film. However, the porosity of the film need not be homogeneous throughout the film. In certain embodiments, there is a porosity gradient and/or layers of varying porosities. Such films can be provided by, e.g., adjusting the ratio of pore-forming precursor to structure-forming precursor during formation of the composite film. The porosity of the films may have continuous or discontinuous pores.

In certain embodiments of the method described herein, the pore size may be increased in size after chemical treatment, exposure to an energy source, and combinations thereof. In other embodiments of the method described herein, the pore size may be decreased in size after chemical treatment, exposure to an energy source, and combinations thereof. Such changes in pore size can be measured, for example, by ellipsometry. The films described herein may have an extinction coefficient measured at 240 nanometers by ellipsometry ranging from 0 to 0.03 or from 0 to 0.025.

In other embodiments, the films described herein are not porous.

The films described herein may have a lower dielectric constant relative to common OSG materials. In certain embodiments, the films described herein have a dielectric constant of about 3.0 or below, or about 2.8 or below, or about 2.7 or below. In one particular embodiment, the dielectric constant for the film ranges from 1.2 to 2.5.

The films are suitable for a variety of uses. The films are particularly suitable for deposition on a semiconductor substrate, and are particularly suitable for use as, e.g., an insulation layer, an interlayer dielectric layer and/or an intermetal dielectric layer. The films can form a conformal coating. The properties exhibited by these films make them particularly suitable for use in Al subtractive technology and Cu damascene or dual damascene technology.

According to claim 1 the composite OSG film or porous OSG film is deposited on a substrate. Suitable substrates include, but are not limited to, semiconductor materials such as gallium arsenide ("GaAs"), silicon, and compositions containing silicon such as crystalline silicon, polysilicon, amorphous silicon, epitaxial silicon, silicon dioxide ("$SiO_2$") silicon glass, silicon nitride, fused silica, glass, quartz, borosilicate glass, and combinations thereof. Other suitable materials include chromium, molybdenum, and other metals commonly employed in semi-conductor, integrated circuits, flat panel display, and flexible display applications. The substrate may have additional layers such as, for example, silicon, $SiO_2$, organosilicate glass (OSG), fluorinated silicate glass (FSG), boron carbonitride, silicon carbide, hydrogenated silicon carbide, silicon nitride, hydrogenated silicon nitride, silicon carbonitride, hydrogenated silicon carbonitride, boronitride, organic-inorganic composite materials, photoresists, organic polymers, porous organic and inorganic materials and composites, metal oxides such as aluminum oxide, and germanium oxide. Still further layers can also be germanosilicates, aluminosilicates, copper and aluminum, and diffusion barrier materials such as, but not limited to, TiN, Ti(C)N, TaN, Ta(C)N, Ta, W, or WN. The films are capable of.adhering to at least one of the foregoing materials sufficiently to pass a conventional pull test, such as ASTM D3359-95a tape pull test. A sample is considered to have passed the test if there is no discernible removal of film.

By using the method described herein to remove at least a portion of the carbon-containing species within the OSG film, the refractive index and extinction coefficient of the OSG film is reduced significantly when compared to OSG film that is not treated with a chemical comprising an oxidizer, an energy source comprising an ultraviolet light source, and combinations thereof. These physical properties of the film improve significantly after both the treatment with a chemical comprising an oxidizer and exposure to an energy source comprising UV light. In one particular embodiment, the composite OSG film has a first dielectric constant, a first hardness, and a first modulus. The composite OSG film is then treated with an oxidizer chemical and exposed to an energy source comprising ultraviolet light and optionally thermal energy to remove at least a portion of the carbon-containing species therein and provide the porous organosilicate which has a second dielectric constant, a second hardness, and a second modulus. The second dielectric constant of the porous organosilicate is substantially the same as or less than the first dielectric constant and the second hardness and second modulus of the porous organosilicate are greater than the first hardness.

Although the method described herein is particularly suitable for providing films and products of the method are largely described herein as films, the invention is not limited thereto. It is understood in certain instances that the terms "OSG films" and "OSG materials" are used interchangeably. Products of the methods described herein can be provided in any form capable of being deposited by CVD, such as coatings, multilaminar assemblies, and other types of objects or materials that are not necessarily planar or thin, and a multitude of objects or materials not necessarily used in integrated circuits.

The method described herein will be illustrated in more detail with reference to the following Examples, but it should be understood that it is not deemed to be limited thereto.

EXAMPLES

Although the method described herein can be performed on any dielectric film, the following examples employ PDEMS™ 2.5 ATRP films. As used herein, the designation "PDEMS™ 2.5 ATRP film" describes low dielectric films having a dielectric constant of about 2.5. The films were deposited using diethoxy methylsilane (DEMS) as the silica-containing precursor provided by Air Products, Inc. of Allentown, PA and alpha-terpinene (ATRP) as the porogen precursor provided by Air Products, Inc. were formed via a plasma enhanced CVD (PECVD) process using an Applied Materials Precision-5000 system in a 200 mm DxZ vacuum chamber that was fitted with an Advance Energy 200 rf generator and using an undoped TEOS process kit. The PDEMS™ 2.5 ATRP films were prepared according to the process described in U.S. Patent No. 6,846,515, which is incorporated herein by reference in its entirety.

In the following examples, unless stated otherwise, properties were obtained from sample films that were deposited onto medium resistivity (8-12 $\Omega$cm) single crystal silicon wafer substrates.

The thickness, film refractive index, and extinction coefficients at 240 nm of each film were determined by reflectometry on a SCI FilmTek 2000 reflectometer.

The dielectric constant of each sample film was determined according to ASTM Standard D150-98. The capacitance-voltage of each film were obtained at 1 MHz with a Solartron Model SI 1260 Frequency Analyzer and MSI Electronics Model Hg 401 single contact mercury probe. The error in capacitance measurements and mercury electrode area (A) was less than 1%. The substrate (wafer) capacitance ($C_{Si}$), background capacitance ($C_b$) and total capacitance ($C_T$) were measured between +20 and -20 volts and the thin film sample capacitance ($C_s$) was calculated by Equation (1):

$$C_s = C_{Si}(C_T - C_b)/[C_{Si} - (C_T - C_b)] \qquad \text{Equation (1)}$$

The dielectric constant of each film was calculated by Equation (2) wherein d is the film thickness, A is the mercury electrode area, and $\varepsilon_0$ is the dielectric constant in vacuum:

$$\varepsilon = \frac{C_S d}{\varepsilon_0 A} \qquad \text{Equation (2)}$$

The total error of the dielectric constant of the film was expected to be less than 6%.

The elastic modulus for each film was taken from 1 x 0.4 cm$^2$ samples cleaved from the center of the wafer and mounted onto an aluminum stub using a low-melting-temperature adhesive, CRYSTALBOND® which is manufactured by Armco Products Inc., of Valley Cottage, N.Y. Indentation tests were performed on a NANOINDENTER® Dynamic Contact Module (DCM) manufactured by MTS Systems Corporation with an ACCUTIP™ Berkovich diamond tip using the continuous stiffness measurement ("CSM") method described in the reference, Oliver et al., "An improved technique for Determining Hardness and Elastic Modulus Using Load and Displacement Sensing Indentation Experiments", J. Material Research, 1992, 7 [6], pp. 1564-1583, incorporated herein by reference in its entirety. A small oscillation was superimposed on the primary loading signal and the resultant system response was analyzed by means of a frequency-specific amplifier. The excitation frequency was held constant throughout the test at 75 Hz (DCM) and the excitation amplitude was controlled such that the resulting displacement amplitude remained constant at 1 nm (DCM).

Each indentation experiment allowed for a continuous measure of the contact stiffness, S. Using the dynamic measure of S, and established formulae for Young's modulus and hardness (Poisson's Ratio = 0.18 for silica, 0.25 for low $\kappa$ films), every individual indentation experiment yielded Young's modulus and hardness as a continuous function of surface penetration. An array of 4 to 5 indents was performed on each sample and a distance of approximately 20 - 25 microns separated successive indents. The results from each indentation experiment were examined and any "outliers" were excluded. The results for Young's modulus and hardness vs. penetration for the indentation experiments of each sample were averaged using discrete displacement windows of approximately 5 nm. Using the data in this window, an average, standard deviation, and confidence interval for each sample were then calculated. The same statistics were likewise calculated for the rest of the discrete windows. Hardness results were obtained and averaged in the same manner. Hardness and Young's modulus were reported as the measured value of hardness at the minimum of the hardness curve (at about 30-50 nm) and the measured value of modulus at the minimum of the modulus curve (at about 30-50 nm). The errors of the modulus and the hardness of the film are expected to be less than 10 percent.

FTIR data was collected on the wafers using a Thermo Nicolet Nexus 470 system equipped with a DTGS KBR detector and KBr beam splitter. Background spectra were collected on similar medium resistivity wafers to eliminate $CO_2$ and water from the spectra. Data was obtained in the range of from 4000 to 400 $cm^{-1}$ by collecting 32 scans with a resolution of 4 $cm^{-1}$. The OMNIC software package was used to process the data. All films were baseline corrected, intensities were normalized to a film thickness of 500 nm, and peaks areas and heights of interest were determined with the OMNIC software.

X-ray Photoelectron Spectroscopy (XPS) data was quantified using relative sensitivity factors and a model that assumed a homogeneous layer. The XPS measurements were obtained on a Phi 5701 LSci system using a monochromated $Alk_{\alpha}$ 1486.6eV X-ray source, an acceptance angle of $\pm7°$, a take off angle of 65°, an analysis area of 800 $\mu m^2$, a sputter rate of 86 Å/min, and ion gun conditions of $Ar^+$, 3 keV, 4 x 4 mm raster. The analysis volume is the product of the analysis area (spot size or aperture size) and the depth of information. Photoelectrons are generated within the X-ray penetration depth (typically many microns), but only the photoelectrons within the top three photoelectron escape depths are detected. Escape depths are on the order of 15-35 Å, which leads to an analysis depth of ~50-100 Å. Typically, 95% of the signal originates from within this depth. $^{29}$Si and $^{13}$C MAS NMR data were collected using a Varian 3.2 mm T3DR probe with spinning speeds of 12-14 kHz at field strength of 9.4 T (400 MHz). Data analysis was done using NUTS software program developed by Acorn NMR, Inc. of Livermore, CA.

In some of the following examples, unless otherwise specified, the UV exposure was performed on a sweeping Fusion VPS/I-600 with a 10" $H^+$ bulb integrated into a 200 mm Dxl chamber attached to an automated Applied Materials P5000 platform. The susceptor temperature was set to 300°C. Samples were exposed to 100% UV power ranging from 0.5 minutes to 10 minutes, preferably from 1 minute to 3 minutes. In some of the following examples, a UV exposure step may be used in addition to the UV cure step (e.g., or the step used to remove the organic material from the composite film to provide the porous OSG film).

In some of the following examples, the exemplary wafers were treated with one of the following chemical compositions provided in the following Table II:

Table II: Chemical Compositions for Treating Exemplary Wafers (All percentages are provided in weight percent and add up to 100 weight percent)

| A | B | C | D | E | F |
|---|---|---|---|---|---|
| THFA (60.4) | DMAC (52.4) | 2-Hexanone (100) | THFA (60.4) | Gly. (52.4) | THFA (60.4) |
| DIW (39.6) | DIW (30) | | DIW (35) | DIW (30) | DIW (37.6) |
| | Amm. acetate (15.6) | | Acetic Acid (2) | Acetic Acid (2) | Acetic Acid (2) |
| | Acetic acid (2) | | Amm. Acetate (2) | Amm. Acetate (15.6) | |
| | | | | | |
| G | H | I | | | |
| THFA (60.4) | HA (50%) (100) | HA (50%) (80) | | | |

(continued)

| G | H | I | | | |
|---|---|---|---|---|---|
| DIW (30.2) | | MEA (20) | | | |
| Acetic Acid (4) | | | | | |
| AF (40% solution) (0.4) | | | | | |
| Gly.(5) | | | | | |

Glossary:

Dimethylacetamide (DMAC)
Tetrahydrofuryl alcohol (THFA)
Deionized (DIW) Water
Ammonium Acetate (Amm. Acetate)
Ammonium Fluoride (AF)
Glycerol (Gly.)
Hydroxylamine (50% solution) (HA)
Methanolamine (MEA)

Example 1: Detection of Carbon-Containing Species within the Low Dielectric OSG Film

$^{29}$Si MAS NMR was used to evaluate the network structure and $^{13}$C MAS NMR was used to evaluate the carbon-containing species within the film. As evidence that there is likely more than one type of carbon in these films, e.g., $CH_3$ covalently bonded to Si and residual carbon-containing species, Table III summarizes the $^{29}$Si MAS NMR and $^{13}$C MAS NMR of the powders scraped from 200 mm wafers. Table III shows that there are different Si species and carbon-containing species present within the film. Table III also shows two types of the carbon-containing species present within the film: one associated with the methyl group bonded to a Si atom or the network-terminating carbon groups and an alkene-like carbon phase. The latter carbon is likely contributing to an increase in the dielectric constant of the film and a decrease in mechanical properties. It is this alkene-like carbon species that the method described herein is trying to remove without damaging the silicate network or the terminal groups which make the film hydrophobic. If the undesired carbon-containing species can be removed from the film without significantly degrading the material such as the film network, there may be improved electrical or mechanical properties in the resultant film.

Table III: $^{29}$Si MAS NMR and $^{13}$C MAS NMR of the powders scraped from 200 mm cured PDEMS™ 2.5 ATRP wafers.

| $^{29}$Si NMR | | | | | |
|---|---|---|---|---|---|
| $Si(OSi)_2(CH_3)_2$ | $Si(OSi)_2(CH_3)(OH)$ | $Si(OSi)_3(CH_3)$ | $Si(OSi)_3(H)$ | $Si(OSi)_3(OH)$ | $Si(OSi)_4$ |
| 4 | 9 | 37 | 3.5 | 15 | 32 |
| | | | | | |
| $^{13}$C NMR | | | | | |
| "C=C" | $CH_3$-Si | | | | |
| 40 | 60 | | | | |

The dielectric constant and mechanical properties of various cured PDEMS™ 2.5 ATRP films that were treated with chemicals comprising an oxidizer, exposed to UV light, treated to additional chemical formulations, and combinations thereof are provided in Table IV. In all of the examples in Table IV, the cured PDEMS™ 2.5 ATRP films were treated with the oxidizing chemical ozone ($O_3$). In examples 3 and 4 in Table IV, the treated PDEMS™ 2.5 ATRP films were exposed to a 1 minute of UV light under the following conditions: broadband H$^+$ bulb, 6000 watt Fusion system, vacuum, and a susceptor temperature of 300°C. Examples 1 and 2 in Table IV shows that the ozone treatment -with or without a subsequent chemical treatment step- increased the dielectric constant of the films and decreased the mechanical properties of the films. However, after exposing the $O_3$-treated films to UV light for a short period of time, the dielectric constant returned to normal or decreased while the mechanical properties of the films increased.

Table IV: Effect on Dielectric Constant and Mechanical Properties after Various Treatments

| Example | Conditions | Dielectric Constant k | Modulus (GPa) | Hardness (GPa) |
|---|---|---|---|---|
| Control Ex. A | Cured PDEMS™ 2.5 ATRP | 2.51 | 6.9 | 1.03 |
| Ex. 1 | Cured PDEMS™ 2.5 ATRP after exposure to $O_3$ for 5 minutes | 3.45 | 5.3 | 0.72 |
| Ex. 2 | Cured PDEMS™ 2.5 ATRP after exposure to $O_3$ for 5 min. and rinse chemistry Comp. C at 75°C for 120 min. | 2.88 | 5.9 | 0.82 |
| Ex. 3 | Cured PDEMS™ 2.5 ATRP after exposure to $O_3$ for 5 min. and exposure to UV for 1 min. | 2.51 | 9.4 | 1.36 |
| Ex. 4 | Cured PDEMS™ 2.5 ATRP after exposure to $O_3$ for 5 min., exposure to rinse chemistry Comp. C at 75°C for 120 min., and exposure to UV for 1 min. | 2.45 | 8.3 | 1.29 |

Comparative Examples: Treatment with one or more chemical cleaning compositions

Cured and uncured PDEMS™ 2.5 ATRP wafers were treated with various chemical compositions (which are provided in Table II above) under various treatment conditions provided in Tables V, VI, and VII. Tables V, VI, and VII further provide thickness, refractive index, and extinction coefficient obtained by reflectometer for each exemplary wafer after treatment with the various cleaning compositions. The PDEMS™ 2.5 ATRP wafers were contacted or dipped into a vessel containing the wet chemicals at various temperatures ranging from 20°C to 80°C. Typical time periods for exposure of the substrate to the various chemical compositions may range from, for example, 1 to 120 minutes. After treatment with the chemical compositions, the wafer was rinsed with deionized water and then dried. Drying was carried out under an inert atmosphere.

After treating the cured films with chemical composition H for 10 and 30 minutes, or Comp. Ex. 1 and 2, respectively, the film thickness decreased slightly, but no changes of refractive index and extinction coefficient was observed for the treated PDEMS™ 2.5 ATRP film compared to Control B (see Table V). After 60 minutes of treatment, the Comp. Ex. 3 film was severely damaged and surface roughness was visible. The FTIR data for the Comp. Ex. 1, 2, and 3 films showed constant decrease of Si-O peak indicating film thickness decreased, but no carbonyl peak at 1735 cm$^{-1}$ was observed. These results showed that chemical compositions comprising hydroxylamine was unable to remove carbon-containing species, but damaged the cured PDEMS™ 2.5 ATRP films at longer exposure times.

Table VI further shows that after treating the cured films with chemical compositions I for 5 min., or Comp. Ex. 4, there was no change of refractive index and extinction coefficient on the PDEMS™ 2.5 ATRP film compared to Control C. After treatment with chemical composition I for 10 min, or Comp. Ex. 5, the film thickness reduced along with the refractive index and extinction coefficient. After treatment with chemical composition I for 30 min., or Comp. Ex. 6, the film deliminated. The FTIR data for Comp. Ex. 4, 5, and 6 films showed a constant decrease of Si-O peak indicating film thickness decreased, but no carbonyl peak at 1735 cm$^{-1}$ was observed. These results showed that chemical compositions comprising hydroxylamine were unable to remove carbon-containing species, but damaged the cured PDEMS™ 2.5 ATRP films at longer exposure times.

Table VII shows that after treatment with various cleaning compositions for up to 30 minutes, there were no change of thickness, refractive index and extinction coefficient on the uncured PDEMS™ 2.5 ATRP when compared to Control D. FTIR data showed no change of the film properties and no evidence of carbonyl species. These results showed that these cleaning compositions were unable to remove porogen and carbon-containing species from the uncured PDEMS™ 2.5 ATRP films.

Table V: Treatment with Chemical Composition H

| Example | Conditions | Thickness Å | Refractive index @632nm | Extinction coefficient @240nm |
|---|---|---|---|---|
| Control B | Cured PDEMS™ 2.5 ATRP | 5196 | 1.3514 | 0.07915 |
| Comparative (Comp.) Example (Ex.) 1 | Cured PDEMS™ 2.5 ATRP treated with Composition H at 70°C for 10 min. | 5182 | 1.3403 | 0.0642 |
| Comp. Ex. 2 | Cured PDEMS™ 2.5 ATRP treated with Composition H at 70°C for 30 min. | 5111 | 1.3471 | 0.0823 |
| Comp. Ex. 3 | Cured PDEMS™ 2.5 ATRP treated with Composition H at 70°C for 60 min. | Unable to fit the model | Unable to fit the model | Unable to fit the model |

Table VI: Treatment with Chemical Compositions I

| Example | Conditions | Thickness Å | Refractive index @632nm | Extinction coefficient @240nm |
|---|---|---|---|---|
| Control C | Cured PDEMS™ 2.5 ATRP | 5251 | 1.3463 | 0.07027 |
| Comp. Ex. 4 | Cured PDEMS™ 2.5 ATRP treated with Composition I at 70°C for 5 min. | 5170 | 1.3440 | 0.08515 |
| Comp. Ex. 5 | Cured PDEMS™ 2.5 ATRP treated with Composition I at 70°C for 10 min. | 4539 | 1.2662 | 0.04186 |
| Comp. Ex. 6 | Cured PDEMS™ 2.5 ATRP treated with Composition I at 70°C for 30 min. | 176 | 1.4929 | 0.0243 |

Table VII: Treatment with Chemical Compositions A, B, D, E, F, and G

| Example | Conditions | Thickness Å | Refractive index @632nm | Extinction coefficient @240nm |
|---|---|---|---|---|
| Control D | Uncured PDEMS™ 2.5 ATRP | 5872 | 1.4512 | 0.0695 |
| Comp. Ex. 7 | Uncured PDEMS™ 2.5 ATRP treated with Composition F at 25°C for 10 min. | 5931 | 1.4511 | 0.0704 |
| Comp. Ex. 8 | Uncured PDEMS™ 2.5 ATRP treated with Composition F at 25°C for 30 min. | 6025 | 1.4530 | 0.0703 |
| Comp. Ex. 9 | Uncured PDEMS™ 2.5 ATRP treated with Composition D at 25°C for 1.0 min. | 5994 | 1.4516 | 0.0703 |
| Comp. Ex. 10 | Uncured PDEMS™ 2.5 ATRP treated with Composition D at 25°C for 30 min. | 5853 | 1.4463 | 0.0678 |
| Comp. Ex. 11 | Uncured PDEMS™ 2.5 ATRP treated with Composition A at 25°C for 10 min. | 6022 | 1.4518 | 0.0704 |
| Comp. Ex. 12 | Uncured PDEMS™ 2.5 ATRP treated with Composition A at 25°C for 30 min. | 5891 | 1.4517 | 0.0903 |
| Comp. Ex. 13 | Uncured PDEMS™ 2.5 ATRP treated with Composition A at 60°C for 30 min. | 6018 | 1.4537 | 0.0699 |
| Comp. Ex. 14 | Uncured PDEMS™ 2.5 ATRP treated with Composition B at 25°C for 30 min. | 5980 | 1.4535 | 0.0692 |

(continued)

| Example | Conditions | Thickness Å | Refractive index @632nm | Extinction coefficient @240nm |
|---------|-----------|-------------|------------------------|-------------------------------|
| Comp. Ex. 15 | Uncured PDEMS™ 2.5 ATRP treated with Composition B at 60°C for 30 min. | 6055 | 1.4519 | 0.0701 |
| Comp. Ex. 16 | Uncured PDEMS™ 2.5 ATRP treated with Composition E at 25°C for 30 min. | 6001 | 1.4498 | 0.0708 |
| Comp. Ex. 17 | Uncured PDEMS™ 2.5 ATRP treated with Composition G at 25°C for 30 min. | 6005 | 1.4522 | 0.06923 |

Example 2: Effect on Various Properties of Cured Porous OSG Films after Exposure to Ozone, Ozone and Wet Chemical Treatment, and Ozone and UV

Cured porous PDEMS™ 2.5 ATRP wafers were processed in a UV-Ozone dry cleaner, or Ultra-Violet Ozone Cleaning Systems , UVOCS Inc., Model T10X10/OES, Serial no. 1034, in which the wafers were exposed to a gaseous ambient containing ozone. Table VIII provides the treatment conditions and the thickness, refractive index, and extinction coefficient obtained by reflectometer for each exemplary wafer. Reflectometer data is provided in Table VIII and shows that after $O_3$ exposure, the refractive indexes @ 632 nm and extinction coefficient @ 240 nm are reduced significantly without thickness change. Additional wet chemical processes, were used to clean the $O_3$ exposed wafer before UV curing. The wet chemicals were a neutral to acidic semi-aqueous solvent and water mixture or C=O containing organic solvents. The formulations of the various wet chemistries are provided in Table II above. The $O_3$ treated substrate was contacted or dipped into a vessel containing the various chemical compositions at a temperature ranging from 20°C to 80°C. Typical time periods for treatment of the substrate to the chemical compositions may range from, for example, 1 to 120 minutes. After contact with the chemical compositions, the substrate may be rinsed by deionized water and then dried. Drying is typically carried out under an inert atmosphere. After additional treatments with the chemical compositions, the refractive index and extinction coefficient are further reduced (see Ex. 10).

Table IX provides the FTIR data obtained for each of the exemplary wafers. As the data in Table IX illustrates, after treatment with $O_3$, the ratio of Si-$CH_3$/SiO showed essentially no change, which indicated that the methyl groups covalently bonded to Si are not effected by treatment with $O_3$ (compare Control E and Ex. 5). The FTIR spectra also showed that after $O_3$ treatment, a strong peak appeared at ~1735cm$^{-1}$ and a broad peak appeared at ~3500 cm$^{-1}$, possibly due to C=O and -OH stretching transitions, respectively (see Ex. 5). This indicates that the carbon-containing species are most likely converted to carbonyl (C=O) or carboxylic acid (COOH) species or carbon-containing by-products by $O_3$ treatment. Further exposure of the wafers to additional cleaning compositions completely removed the carbonyl peak at ~1735cm$^{-1}$, but the -OH bond remained (see Ex. 6, 7, and 8). This -OH bond may result from hydrogen bonded $H_2O$ on the surface. An additional UV exposure step was able to completely remove the carbonyl (C=O) or carboxylic acid (COOH) species or carbon-containing by-products and restored the film structure (see Ex. 9 and Ex. 10).

Table X provides the XPS data for certain examples. The XPS data shows the species observed on the as-received cured PDEMS 2.5 (Control E) and with $O_3$ exposed cured PDEMS 2.5 surfaces (Ex. 5) and after sputtered surfaces by XPS and ESCA. These species include R-Si, hydrocarbons, O-containing organics, minor amounts of fluorides and C-N. Ex. 5 also contained O-C=O functionality (possibly an ester), which is consistent with the finding from FTIR. Comparing the carbon concentrations of Control E and Ex. 5, $O_3$ treatment reduced the carbon concentration from 24.1% to 15.3% on the as-received surface and from 19.3% to 7.1% on the -10 nm surface. These results provide further evidence that the carbon-containing species are effectively removed by treatment with $O_3$.

Table VII Reflectometer data of cured PDEMS™ 2.5 ATRP film after treatment with $O_3$, various cleaning compositions and UV exposure

| Example | Conditions | Thickness Å | Refractive index @632no | Extinction coefficient @240nm |
|---------|-----------|-------------|------------------------|-------------------------------|
| Control E | Cured PDEMS™ 2.5 ATRP | 5221 | 1.3548 | 0.066 |
| Ex. 5 | Cured PDEMS™ 2.5 ATRP treated with $O_3$ for 5 min. | 5123 | 1.3123 | 0.0086 |

(continued)

| Example | Conditions | Thickness Å | Refractive index @632no | Extinction coefficient @240nm |
|---|---|---|---|---|
| Ex. 6 | Cured PDEMS™ 2.5 ATRP treated with $O_3$ for 5 min. and Composition A at 25°C for 30 min. | 5159 | 1.2916 | 0 |
| Ex. 7 | Cured PDEMS™ 2.5 ATRP treated with $O_3$ for 5 min. and Composition B at 25°C for 30 min. | 5186 | 1.2901 | 0 |
| Ex. 8 | Cured PDEMS™ 2.5 ATRP treated with $O_3$ for 5 min. and Composition C at 75°C for 120 min. | 5148 | 1.29 | 0 |
| Ex. 9 | Cured PDEMS™ 2.5 ATRP treated with $O_3$ for 5 min. and UV for 1 min. | 4871 | 1.29902 | 0.01351 |
| Ex. 10 | Cured PDEMS™ 2.5 ATRP treated with $O_3$ for 5 min.; Composition C at 75°C for 120 min.; and exposed to UV for 1 min. | 4867 | 1.30241 | 0.00873 |

Table IX: FTIR data of cured PDEMS2.5 film after $O_3$, exposure to wet chemical cleaning chemical and UV exposure

| Example | Bond Ratio | | Bond (Integrated Area) | |
|---|---|---|---|---|
| | Si-CH$_3$/SiO | C-H/SiO | C=O | OH |
| Control E | 0.018 | 0.013 | N | N |
| Ex. 5 | 0.017 | 0.007 | Y (0.8781) | Y (1.6502) |
| Ex. 6 | 0.018 | 0.008 | N | Y (1.4678) |
| Ex. 7 | 0.018 | 0.008 | N | Y (2.067) |
| EX. 8 | 0.017 | 0.008 | N | Y (0.8715) |
| Ex. 9 | 0.015 | 0.007 | N | N |
| Ex. 10 | 0.016 | 0.008 | N | N |

Table X: Concentrations (in %)[a] and Elemental Ratios Before and After Ion Sputtering by XPS and ESCA

| Example | C | N | O | F | Si | O/Si | C/Si |
|---|---|---|---|---|---|---|---|
| Control E | 24.1 | 0.2 | 49.6 | 0.1 | 26.3 | 1.89 | 0.92 |
| Ex. 5 | 15.3 | 0.2 | 58.8 | 0.0 | 25.8 | 2.29 | 0.59 |
| Control E taken at -10 nm | 19.3 | 0.4 | 47.5 | 0.0 | 33.0 | 1.44 | 0.59 |
| Ex. 5 taken at -10 nm | 7.1 | 0.5 | 57.8 | 0.1 | 34.7 | 1.67 | 0.21 |
| [a] Normalized to 100% of the elements detected. XPS does not detect H or He. | | | | | | | |

Example 3: Effect on Various Properties of Cured Porous OSG Films After Treatment with Ozonated Water and Exposure to UV

Cured porous PDEMS wafers having a dielectric constant of 2.5 were immersed in ozonated water ($O_3$/$H_2O$), which contains 30 parts per million (ppm) ozone in water at approximately 21.8°C for various times provided in Tables XI and XII. Reflectometer data (Table XI) shows that after immersion in ozonated water, the refractive indexes @ 632 nm and extinction coefficient @ 240 nm are reduced significantly as the immersion time increased. The thicknesses of the wafers are essentially not changed.
Table XII provides the FTIR data obtained for each of the exemplary wafers. As the data in Table XII illustrates, after immersion in ozonated water for up to 60 minutes, the ratio of Si-CH$_3$/SiO shows essentially no change, which indicates that the methyl groups covalently bond to Si are not effected by the ozonated water (compare Control F and Ex. 11-14). The FTIR spectra also shows that after immersion in ozonated water for 5 min, a strong peak appears at ~1735cm$^{-1}$ and a broad peak appears at ~3500 cm$^{-1}$, due to C=O and -OH stretching transitions respectively. This indicates that the carbon-containing species is most likely converted to carbonyl (C=O) or carboxylic acid (COOH) species or carbon-containing by-products after immersion in ozonated for 5 min (see Control F and Ex. 11 - 14). There are no significant increase of carbonyl (C=O) or carboxylic acid (COOH) species at longer immersion times.

Table XI: Reflectometer data of Exemplary OSG films after treatment with $O_3/H_2O$

| Example | Conditions | Thickness Å | Refractive index @632nm | Extinction coefficient @240nm |
|---------|-----------|-------------|------------------------|-------------------------------|
| Control F | Cured PDEMS™ 2.5 ATRP | 5233 | 1.3673 | 0.06903 |
| Ex. 11 | Cured PDEMS™ 2.5 ATRP treated with $O_3/H_2O$ for 5 min. | 5180 | 1.3527 | 0.03252 |
| Ex. 12 | Cured PDEMS™ 2.5 ATRP treated with $O_3/H_2O$ for 10 min. | 5169 | 1.3514 | 0.02994 |
| Ex. 13 | Cured PDEMS™ 2.5 ATRP treated with $O_3/H_2O$ for 30 min. | 5189 | 1.3388 | 0.02198 |
| Ex. 14 | Cured PDEMS™ 2.5 ATRP treated with $O_3/H_2O$ for 60 min. | 5207 | 1.3286 | 0.0195 |

Table XII: FTIR data of Exemplary OSG films after immersion in $O3/H_2O$

| Examples | Bond Ratio | | Bond (Integrated Area) | |
|----------|-----------|-----------|------------------------|----|
| | $Si-CH_3/SiO$ | C-H/SiO | C=O | OH |
| Control F | 0.018 | 0.013 | N | N |
| Ex. 11 | 0.018 | 0.011 | Y (0.5057) | Y (1.2648) |
| Ex. 12 | 0.017 | 0.013 | Y (0.5033) | Y (1.8899) |
| Ex. 13 | 0.018 | 0.011 | Y (0.4367) | Y (1.8525) |
| Ex. 14 | 0.018 | 0.009 | Y (0.396) | Y (2.1975) |

Example 4: Effect on Various Properties of Cured Porous OSG Films After Treatment with SPM

Cured porous PDEMS™ 2.5 ATRP wafers having a dielectric constant bf 2.5 were immersed in SPM (98% sulfuric acid:30% $H_2O_2$ in a 10:1 molar ratio) at 120°C for various times provided in Tables XIII and XIV. Reflectometer data (Table XIII) shows that after immersion in SPM, the refractive indexes @ 632 nm decreased slightly; the extinction coefficient @ 240 nm deceased significantly; and the thickness of the wafers changed slightly as the immersion time increased.

Table XIV provides the FTIR data obtained for each of the exemplary wafers. As the data in Table XIV illustrates, after immersion in SPM for up to 30 minutes, the ratio of $Si-CH_3/SiO$ decreased slightly, which indicates that the methyl groups covalently bond to Si are slightly effect by immersion to SPM. The FTIR spectra also shows that after immersion in SPM for 1 minute, a strong peak appears at ~1735cm$^{-1}$ and a broad peak appears at ~3500 cm$^{-1}$, due to C=O and -OH stretching transitions, respectively. This indicates that the carbon-containing species is most likely converted to carbonyl (C=O) or carboxylic acid (COOH) species after immersion in SPM for 1 min. The continue decreasing of the integrated area of carbonyl (C=O) stretching indicates that the carbonyl (C=O) or carboxylic acid (COOH) species tend to be removed by SPM at longer immersion times.

Table XIII: Reflectometer data of Cured Porous OSG Films after immersion in SPM

| Example | Conditions | Thickness Å | Refractive index @632no | Extinction coefficient @240nm |
|---------|-----------|-------------|-------------------------|-------------------------------|
| Control G | Cured PDEMS™ 2.5 ATRP | 5233 | 1.3673 | 0.06903 |

(continued)

| Example | Conditions | Thickness Å | Refractive index @632no | Extinction coefficient @240nm |
|---|---|---|---|---|
| Ex. 15 | Treatment with SPM for 1 min. | 5034 | 1.3869 | 0.02285 |
| Ex. 16 | Treatment with SPM for 5 min. | 4965 | 1.3468 | 0.00166 |
| Ex. 17 | Treatment with SPM for 10 min. | 4973 | 1.3485 | 0.00061 |
| Ex. 18 | Treatment with SPM for 30 min. | 4946 | 1.3455 | 0.00157 |

Table XIV: FTIR data of Cured Porous OSG films after immersion in SPM

| Examples | Bond Ratio | | Bond (Integrated Area) | |
|---|---|---|---|---|
| | $Si-CH_3/SiO$ | C-H/SiO | C=O | OH |
| Control G | 0.018 | 0.013 | N | N |
| Ex. 15 | 0.018 | 0.009 | Y (0.8165) | Y (2.3455) |
| Ex. 16 | 0.016 | 0.009 | Y (0.3464) | Y (2.1351) |
| Ex. 17 | 0.016 | 0.008 | Y (0.2403) | Y (2.2377) |
| Ex. 18 | 0.015 | 0.009 | Y (0.1836) | Y (2.4866) |

Example 5: Effect on Various Properties of Uncured Porous OSG Films After Treatment with Ozone and Various Cleaning Chemistries

Uncured PDEMS™ 2.5 ATRP wafers were processed in a UV-Ozone dry cleaner (UVOC), in which the wafers were exposed to gaseous ambient containing ozone. Reflectometer data (Table XV) shows that after $O_3$ exposure, the refractive indexes @ 632 nm and extinction coefficient @ 240 nm were reduced significantly, with a slight decrease of thickness. Additional wet chemical processes were used to clean the 03 exposed wafer before UV curing. The wet chemicals are neutral to acidic semi-aqueous solvent and water mixture or C=O containing organic solvents. Examples of the chemicals are Compositions A through C, which are provided in Table II herein.

FTIR data (Table XVI) shows that after exposure to $O_3$, the ratio of $Si-CH_3/SiO$ are essentially not changed, which indicates that the methyl groups covalently bond to Si are not effected by exposure to $O_3$. On the other hand, the ratio of C-H/SiO decreased significantly, which indicates that the porogen is substantially removed by the $O_3$ exposure. FTIR spectra also shows that after $O_3$ exposure, a strong peak appears at ~1735cm$^{-1}$ and a broad peak appears at ~3500 cm$^{-1}$, due to C=O and -OH stretching transitions, respectively. This indicates that the carbon-containing species is most likely converted to carbonyl (C=O) or carboxylic acid (COOH) species by $O_3$ exposure. Wet chemicals cleaning removed some of the carbonyl peak at ~1735cm$^{-1}$, but was not effective enough to completely remove the C=O and -OH species.

Table XV: Reflectometer data of Uncured OSG Films After $O_3$ exposure and Wet Chemical Cleaning

| Example | Conditions | Thickness Å | Refractive index @632nm | Extinction coefficient @240nm |
|---|---|---|---|---|
| Control H | Uncured PDEMS™ 2.5 ATRP | 6036 | 1.46143 | 0.06854 |
| Ex. 19 | Treatment with $O_3$ for 5 min. | 5728 | 1.3979 | 0.0313 |
| Ex. 20 | Treatment with $O_3$ for 5 min. and Comp. A at 25°C for 30 min. | 5861 | 1.335 | 0.0242 |
| Ex. 21 | Treatment with $O_3$ for 5 min. and Comp. B at 25°C for 30 min. | 5861 | 1.335 | 0.0242 |

(continued)

| Example | Conditions | Thickness Å | Refractive index @632nm | Extinction coefficient @240nm |
|---|---|---|---|---|
| Ex. 22 | Treatment with $O_3$ for 5 min. and Comp. C at 75°C for 120 min. | 5873 | 1.3351 | 0.02898 |

Table XVI: FTIR data of Uncured OSG Films After $O_3$ exposure and Wet Chemical Cleaning

| Examples | Bond Ratio | | Bond (Integrated Area) | |
|---|---|---|---|---|
| | Si-CH$_3$/SiO | C-H/SiO | C=O | OH |
| Control H | 0.026 | 0.108 | N | N |
| Ex. 19 | 0.024 | 0.032 | Y (2.71) | Y (4.2778) |
| Ex. 20 | 0.023 | 0.027 | Y (1.1919) | Y (2.2166) |
| Ex. 21 | 0.024 | 0.023 | Y (0.9676) | Y (2.7764) |
| Ex. 22 | 0.023 | 0.028 | Y (1.0931) | Y (1.4436) |

Example 6: Effect on Various Properties of Uncured Porous OSG Films After Ozonated Water Treatment

Uncured PDEMS™ 2.5 ATRP wafers were immersed in ozonated water ($O_3$/$H_2O$), which contains 30 parts per million (ppm) ozone in water at approximately 21.8°C for various times provided in Tables XVII and XVIII. Reflectometer data (Table XVII) show that after immersion in ozonated water, the extinction coefficient @ 240 nm was reduced significantly as the immersion time increased. There were slight changes on the refractive indexes and the thickness of the wafers.

FTIR data (Table XVIII) shows that after immersion in ozonated water for up to 60 minutes, the ratio of Si-CH$_3$/SiO are essentially not changed, which indicates that the methyl groups covalently bond to Si are not effect by the ozonated water. On the other hand, the ratio of C-H/SiO decreased significantly, which indicates that the porogen is substantially removed by immersion in the ozonated water. FTIR spectra also shows that after immersion in the ozonated water for 5 minutes, a strong peak appears at ~1735 cm$^{-1}$ and a broad peak appears at ~3500 cm$^{-1}$, due to C=O and -OH stretching transitions, respectively. This indicates that the carbon-containing species is most likely converted to carbonyl (C=O) or carboxylic acid (COOH) species after immersion in ozonated water for 5 minutes. There are no significant increase of carbonyl (C=O) or carboxylic acid (COOH) species at longer immersion times.

Table XVII: Reflectometer data of Uncured PDEMS2.5 film after immersion in Ozonated Water

| Example | Conditions | Thickness Å | Refractive index @632nm | Extinction coefficient @240nm |
|---|---|---|---|---|
| Control I | Uncured PDEMS™ 2.5 ATRP | 6036 | 1.46143 | 0.06854 |
| Ex. 23 | Treatment with $O_3$/$H_2O$ for 5 min. | 5979 | 1.4609 | 0.03573 |
| Ex. 24 | Treatment with $O_3$/$H_2O$ for 10 min. | 5965 | 1.4593 | 0.03244 |
| Ex. 25 | Treatment with $O_3$/$H_2O$ for 30 min. | 5760 | 1.46473 | 0.02645 |
| Ex. 26 | Treatment with $O_3$/$H_2O$ for 60 min. | 5774 | 1.4523 | 0.02319 |

Table XVIII: FTIR data of Uncured PDEMS2.5 film after immersion in Ozonated Water

| Wafers | Bond Ratio | | Bond (Integrated Area) | |
|---|---|---|---|---|
| | Si-CH$_3$/SiO | C-H/SiO | C=O | OH |
| Control I | 0.026 | 0.108 | N | N |
| Ex. 23 | 0.025 | 0.066 | Y (1.4755) | Y (1.8343) |
| Ex. 24 | 0.025 | 0.057 | Y (1.8459) | Y (2.26391) |
| Ex. 25 | 0.024 | 0.047 | Y (1.9986) | Y (3.2615) |
| Ex. 26 | 0.024 | 0.042 | Y (2.0823) | Y (3.824) |

Example 7: Effect on Various Properties of Uncured Porous OSG Films After SPM Exposure

Uncured PDEMS2.5 wafers were immersed in SPM (98% sulfuric acid :30% H$_2$O$_2$=10:1) at 120°C for various times. Reflectometer data (Table XVIX) shows that after immersion in SPM, the refractive indexes @ 632 nm and extinction coefficient @ 240 nm decreased significantly as the immersion time increased. There are also slight decreases on the thickness of the wafers as the immersion time increased.

FTIR data (Table XX) shows that after immersion in SPM up to 10 minutes, the ratio of Si-CH$_3$/SiO decreased slightly, which indicates that the methyl groups covalently bond to Si are slightly effected by SPM. The significant change of C-H/SiO ratio indicated that SPM effectively removed porogen from uncured PDEMS film. FTIR spectra also shows that after immersion in SPM for 1 minutes, a strong peak appears at ~1735cm$^{-1}$ and a broad peak appears at ~3500 cm$^{-1}$, due to C=O and -OH stretching transitions, respectively. This indicates that the carbon-containing species is most likely converted to carbonyl (C=O) or carboxylic acid (COOH) species after immersion in SPM for 1 minute. The carbonyl (C=O) or carboxylic acid (COOH) species tended to be removed by SPM at longer immersion times. It is observed that after immersion in SPM, the low C-H /SiO ratios are close to that of the cured PDEMS 2.5 wafers (see Control A - G).

Table XVIX: Reflectometer data of Uncured PDEMS2.5 film after immersion in SPM

| Example | Conditions | Thickness Å | Refractive index @632nm | Extinction coefficient @240nm |
|---|---|---|---|---|
| Control J | Uncured PDEMS™ 2.5 ATRP | 6036 | 1.46143 | 0.06854 |
| Ex. 27 | Treatment with SPM for 1 min. | 6184 | 1.4174 | 0.06487 |
| Ex. 28 | Treatment with SPM for 5 min. | 5663 | 1.30578 | 0.0000026 |
| Ex. 29 | Treatment with SPM for 10 min. | 5472 | 1.29811 | 0.0000003 |

Table XX: FTIR data of Uncured PDEMS2.5 film after immersion in SPM

| Wafers | Bond Ratio | | Bond (Integrated Area) | |
|---|---|---|---|---|
| | Si-CH$_3$/SiO | C-H/SiO | C=O | OH |
| Control J | 0:026 | 0.108 | N | N |
| Ex. 27 | 0.024 | 0.055 | Y (1.9507) | Y (3.3962) |
| Ex. 28 | 0.019 | 0.014 | Y (0.4322) | Y (3.0263) |
| Ex. 29 | 0.017 | 0.009 | Y (0.3032) | Y (2.895) |

Prophetic Example 8: Effect on Various Properties of Cured Porous OSG Films After Treatment with hydrazine

Cured porous PDEMS™ 2.5 ATRP wafers having a dielectric constant of 2.5 are immersed in a hydrazine solution (35 wt% hydrazine in water) at 70°C for 1, 5, 10, and 30 minutes. Reflectometer data shows that after immersion in the hydrazine solution, the refractive indexes @ 632 nm will decrease; the extinction coefficient @ 240 nm will decrease; and the thickness of the wafers will change slightly as the immersion time increases.

The FTIR data will show that there is a significant reduction in the hydrocarbon region of the spectrum, i.e. the C-H/SiO ratio will be lowered, yet the $CH_3$-Si peak area remains unchanged. This shows that the reductive chemical treatment is selective to the removal of the carbon containing species and not the network terminating carbon species.

The dielectric constant of the film is lowered from 2.5 to 2.3 and the mechanical properties remain equal to the untreated PDEMS 2.5 film. Upon exposure of the hydrazine treated sample, the dielectric constant will decrease to 2.2 and the modulus of the film will increase by 5%.

Prophetic Example 9: Effect on Various Properties of Cured Porous OSG Films After Treatment with oxalic acid.

Cured porous PDEMS™ 2.5 ATRP wafers having a dielectric constant of 2.5 are immersed in an oxalic acid solution for 1, 5, 10, and 30 minutes. Reflectometer data shows that after immersion in the oxalic acid solution, the refractive indexes @ 632 nm will decrease; the extinction coefficient @ 240 nm will decrease; and the thickness of the wafers will change slightly as the immersion time increases.

The dielectric constant remains unchanged after the exposure to the oxalic acid solution, but the mechanical properties of the film decreases by 5%. Upon exposure to UV light for 1 minute, the dielectric constant was reduced from 2.5 to 2.3 and the modulus of the film increased by 10%.

Example 10: Effect of Treatment and Exposure on Ellipsometry Data on Cured PDEMS 2.5 Films

Example 10 illustrates that the pore size of the material is changing with the modification and removal of the non-framework carbon from the UV-cured porous PDEMS films. These results may explain the increased mechanical properties and equivalent dielectric constant of the films as compared to the untreated PDEMS 2.5 films.

Ellipsometric porosimetry (EP) was conducted on a SOPRA EP-12 ellipsometer manufactured by SOPRA S.A. of France, using the solvent toluene as the adsorbate. EP measures the change of the optical properties and thickness of the materials during adsorption and desorption of either an organic solvent or water at reduced pressure. The analysis provides the porosity of the dielectric material, pore size distribution of the micropores and mesopores, cumulative surface area, pore interconnectivity, Young's modulus, thickness and refractive index. Toluene was dosed into the chamber and the refractive index of the film was measured. The partial pressure of toluene was varied between 0.01 and 0.97 to obtain the adsorption/desorption isotherms for the exemplary film. Based upon the changes in refractive index of the film, the amount of toluene adsorbed by the film can be calculated from Equation (3) where $n_{rl}$ is the refractive index of the film with liquid in the pores, $n_{re}$ is the refractive index of the porous film before exposure to the adsorbate, and $n_l$ is the refractive index of the liquid adsorbate.

$$V = \frac{\left(\dfrac{n_{rl}^2 - 1}{n_{rl}^2 + 2}\right) - \left(\dfrac{n_{re}^2 - 1}{n_{re}^2 + 2}\right)}{\left(\dfrac{n_l^2 - 1}{n_l^2 + 2}\right)} \quad \text{Equation (3)}$$

Using the WinElli II software developed at SOPRA, the pore size and pore size distribution can be determined from the adsorption/desorption isotherms using either the Kelvin and/or the Dubinin / Radushkevitch equations.

Table XXI provides the pore size and pore size distribution of PDEMS 2.5 without removal of carbon-containing species from the film and two PDEMS films treated with ozone. The exemplary films are Examples 3 and 4 and Control Sample A from Example 1. Table XXI shows that the pore diameter is increased by 25%, the total micropore volume decreases by 15%, and the mesopore volume increase by 4%. These changes in the pore size and distribution of pores suggest that there have been significant changes to the pore structure using oxidative or reductive carbon modification techniques. Changes in the pore structure of these films can have significant influence on both the mechanical and insulation properties of porous dielectric films.

Table XXI: EP data of Cured PDEMS 2.5 film after Exposure to $O_3$

| Film | Condition | Average micropore diameter (nm) | Total micropore volume | Percent of porosity as mesopores |
|---|---|---|---|---|
| Control A | Cured PDEMS™ 2.5 ATRP | 11.4 | 0.281 | 2% |
| Ex. 3 | Treatment with $O_3$ for 5 min. and exposure to UV for 1 min. | 14.6 | 0.243 | 6% |
| Ex. 4 | Treatment with $O_3$ for 5 min.; treatment with rinse chemistry Comp. C at 75°C for 120 min. and exposure to UV for 1 min | 14.4 | 0.235 | 6% |

**Claims**

1. A method for forming an organosilicate film on a substrate comprising:

   providing a composite organosilicate film wherein the composite organosilicate film is deposited from a composition comprising at least one silicon-containing precursor and at least one porogen-containing precursor and wherein the composite organosilicate film comprises carbon-containing species; and

   exposing the composite organosilicate film to an energy source comprising ultraviolet light, wherein the ultraviolet light is selected from the group consisting of near ultraviolet light and middle ultraviolet light; and treating the composite organosilicate film to a chemical comprising an oxidizer selected from the group consisting of ozone, ozonated water, sulfuric acid peroxide mixture and combinations thereof,

   to remove at least a portion of the carbon-containing species contained therein and provide a porous organosilicate film wherein the refractive index and extinction coefficient of the porous organosilicate film are reduced when compared to the composite organosilicate film and wherein

   the treating step is conducted prior to the exposing step.

2. The method of claim 1 for forming an organosilicate film, wherein the composite organosilicate film is provided by forming it via vapor deposition.

3. The method of claim 1 or 2 wherein the energy source further comprises at least one chosen from a thermal source, $\alpha$-particles, $\beta$-particles, $\gamma$-rays, x-rays, high energy electron, electron beam, visible light, infrared light, microwave, radio-frequency wavelengths, and combinations thereof.

4. The method of claim 1 or 2 wherein the oxidizer comprises ozone.

5. The method of claim 1 or 2 wherein the oxidizer comprises ozonated water.

6. The method of claim 1 or 2 wherein the oxidizer comprises sulfuric acid peroxide mixture.

7. The method of claim 1 or 2 wherein the substrate is at least one selected from silicon glass, silicon nitride, fused silica, glass, quartz, borosilicate glass, and combinations thereof.

8. The method of claim 1 or 2 wherein the at least one silicon-containing precursor is chosen from diethoxymethylsilane, tetraethoxysilane, dimethyldiethoxysilane, dimethyldimethoxysilane, dimethylethoxysilane, triethoxysilane, trimethylphenoxysilane, phenoxysilane, hexamethyldisiloxane, 1,1,2,2-tetramethyldisiloxane, octamethyltrisiloxane, methyltriethoxysilane, methyltriacetoxysilane, tetraacetoxysilane, dimethylsilacyclobutane, octamethylcyclotetrasiloxane, 1,3,5,7-tetramethylcyclotetrasiloxane, methylsilane, dimethylsilane, trimethylsilane, tetramethylsilane, methylene bridged alkoxy silanes, and combinations thereof.

9. The method of claim 1 or 2 wherein the at least one porogen precursor is chosen from alpha-terpinene, limonene, cyclohexane, cyclooctane, bicyclohexadiene, gamma-terpinene, camphene, dimethylhexadiene, ethylbenzene, norbonadiene, cyclopentene oxide, 1,2,4-trimethylcyclohexane, 1,5-dimethyl-1,5-cyclooctadiene, camphene, adamantane, 1,3-butadiene, substituted dienes, decahydronaphthelene, toluene, and combinations thereof.

10. The method of claim 1 or 2 wherein the at least one porogen precursor comprises a gaseous hydrocarbon having from 1 to 13 carbon atoms.

11. The method of claim 1 or 2 wherein the substrate is selected from an integrated circuit, a flat panel display, and a flexible display.

12. Method according to claim 1, the resulting porous organosilicate film comprising: a dielectric constant ranging from 1.2 to 2.5 and an extinction coefficient of the film measured at 240 nm by ellipsometer ranging from 0 to 0.03.

13. Method according to claim 12, the resulting porous organosilicate film comprising pores wherein the average size of the pores is about 100 nanometers or less.

14. Method according to claim 12, wherein the extinction coefficient of the film measured at 240 nm ranges from 0 to 0.025.

**Patentansprüche**

1. Verfahren zum Bilden eines Organosilikatfilms auf einem Substrat, umfassend:

Bereitstellen eines Organosilikatkompositfilms, wobei der Organosilikatkompositfilm von einer Zusammensetzung, umfassend mindestens einen siliciumhaltigen Vorläufer und mindestens einen porogenhaltigen Vorläufer, abgeschieden wird und wobei der Organosilikatkompositfilm kohlenstoffhaltige Spezies umfasst; und
Aussetzen des Organosilikatkompositfilms einer Energiequelle, umfassend Ultraviolettlicht, wobei das Ultraviolettlicht aus der Gruppe ausgewählt ist, die aus nahem Ultraviolett-Licht und mittlerem Ultraviolett-Licht besteht; und
Behandeln des Organosilikatkompositfilms mit einer Chemikalie, umfassend ein Oxidans, welches aus der Gruppe ausgewählt ist, die aus Ozon, ozonisiertem Wasser, Schwefelsäure/Peroxid-Gemisch und Kombinationen davon besteht,
um mindestens einen Teil der darin enthaltenen kohlenstoffhaltigen Spezies zu entfernen und um einen porösen Organosilikatfilm bereitzustellen, wobei der Brechungsindex und Extinktionskoeffizient des porösen Organosilikatfilms verringert sind, wenn mit dem Organosilikatkompositfilm verglichen wird, und wobei der Behandlungsschritt vor dem Aussetzungsschritt durchgeführt wird.

2. Verfahren nach Anspruch 1 zum Bilden eines Organosilikatfilms, wobei der Organosilikatkompositfilm durch Bilden davon über Dampfabscheidung bereitgestellt wird.

3. Verfahren nach Anspruch 1 oder 2, wobei die Energiequelle ferner mindestens eines umfasst, welches aus einer thermischen Quelle, $\alpha$-Teilchen, $\beta$-Teilchen, $\gamma$-Strahlen, Röntgenstrahlen, Hochenergieelektron, Elektronenstrahl, sichtbarem Licht, Infrarotlicht, Mikrowelle, Radiofrequenzwellenlängen und Kombinationen davon ausgewählt ist.

4. Verfahren nach Anspruch 1 oder 2, wobei das Oxidans Ozon umfasst.

5. Verfahren nach Anspruch 1 oder 2, wobei das Oxidans ozonisiertes Wasser umfasst.

6. Verfahren nach Anspruch 1 oder 2, wobei das Oxidans Schwefelsäure/Peroxid-Gemisch umfasst.

7. Verfahren nach Anspruch 1 oder 2, wobei das Substrat mindestens eines ist, welches aus Siliciumglas, Siliciumnitrid, Kieselglas, Glas, Quarz, Borosilikatglas und Kombinationen davon ausgewählt ist.

8. Verfahren nach Anspruch 1 oder 2, wobei der mindestens eine siliciumhaltige Vorläufer aus Diethoxymethylsilan, Tetraethoxysilan, Dimethyldiethoxysilan, Dimethyldimethoxysilan, Dimethylethoxysilan, Triethoxysilan, Trimethylphenoxysilan, Phenoxysilan, Hexamethyldisiloxan, 1,1,2,2-Tetramethyldisiloxan, Octamethyltrisiloxan, Methyltriethoxysilan, Methyltriacetoxysilan, Tetraacetoxysilan, Dimethylsilacyclobutan, Octamethylcyclotetrasiloxan, 1,3,5,7-Tetramethylcyclotetrasiloxan, Methylsilan, Dimethylsilan, Trimethylsilan, Tetramethylsilan, methylenverbrückten Alkoxysilanen und Kombinationen davon ausgewählt ist.

9. Verfahren nach Anspruch 1 oder 2, wobei der mindestens eine Porogenvorläufer aus alpha-Terpinen, Limonen, Cyclohexan, Cyclooctan, Bicyclohexadien, gamma-Terpinen, Camphen, Dimethylhexadien, Ethylbenzen, Norbonadien, Cyclopentenoxid, 1,2,4-Trimethylcyclohexan, 1,5-Dimethyl-1,5-cyclooctadien, Camphen, Adamantan, 1,3-Butadien, substituierten Dienen, Decahydronaphthelen, Toluol und Kombinationen davon ausgewählt ist.

10. Verfahren nach Anspruch 1 oder 2, wobei der mindestens eine Porogenvorläufer einen gasförmigen Kohlenwasserstoff mit 1 bis 13 Kohlenstoffatomen umfasst.

11. Verfahren nach Anspruch 1 oder 2, wobei das Substrat aus einer integrierten Schaltung, einem Flachbildschirm und einer flexiblen Anzeigevorrichtung ausgewählt ist.

12. Verfahren gemäß Anspruch 1, wobei der resultierende poröse Organosilikatfilm umfasst: eine Dielektrizitätskonstante im Bereich von 1,2 bis 2,5 und einen Extinktionskoeffizienten des Films, der bei 240 nm mit einem Ellipsometer gemessen wird, im Bereich von 0 bis 0,03.

13. Verfahren gemäß Anspruch 12, wobei der resultierende poröse Organosilikatfilm Poren umfasst, wobei die mittlere Größe der Poren etwa 100 Nanometer oder weniger beträgt.

14. Verfahren gemäß Anspruch 12, wobei der Extinktionskoeffizient des Films, der bei 240 nm gemessen wird, im Bereich von 0 bis 0,025 liegt.


**Revendications**

1. Procédé de formation d'un film organosilicate sur un substrat, comprenant à :

   fournir un film organosilicate composite, ledit film organosilicate composite étant déposé à partir d'une composition comprenant au moins un précurseur contenant un silicium et au moins un précurseur contenant un porogène, et ledit film organosilicate composite comprenant une espèce contenant du carbone ; et

   exposer le film organosilicate composite à une source d'énergie comprenant la lumière ultraviolette, ladite lumière ultraviolette étant choisie dans le groupe comprenant la lumière proche de l'ultraviolet et la lumière ultraviolette moyenne ; et
   traiter le film organosilicate composite à un produit chimique comprenant un oxydant choisi dans le groupe constitué de l'ozone, l'eau ozonée, un mélange d'acide sulfurique et de peroxyde et des combinaisons de ceux-ci,

   pour éliminer au moins une partie des espèces contenant du carbone contenue dans celui-ci et fournir un film organosilicate poreux, l'indice de réfraction et le coefficient d'extinction du film organosilicate poreux étant réduits par comparaison à ceux du film organosilicate composite et

   l'étape de traitement intervenant avant l'étape d'exposition.

2. Procédé selon la revendication 1 pour former un film organosilicate, ledit film organosilicate composite étant formé par dépôt en phase vapeur.

3. Procédé selon la revendication 1 ou 2, dans lequel la source d'énergie comprend en outre au moins un élément choisi parmi une source thermique, des particules $\alpha$, des particules $\beta$, des rayons y, des rayons X, des électrons à haute énergie, un faisceau d'électrons, la lumière visible, la lumière infrarouge, les micro-ondes, les longueurs d'ondes de radio-fréquences et les combinaisons de ceux-ci.

4. Procédé selon la revendication 1 ou 2, dans lequel l'oxydant comprend l'ozone.

5. Procédé selon la revendication 1 ou 2 dans lequel l'oxydant comprend l'eau ozonée.

6. Procédé selon la revendication 1 ou 2, dans lequel l'oxydant comprend un mélange de peroxyde et d'acide sulfurique.

**7.** Procédé selon la revendication 1 ou 2, dans lequel le substrat est au moins un élément choisi parmi le verre de silicium, le nitrure de silicium, la silice fondue, le verre, le quartz, le verre borosilicate et des combinaisons de ceux-ci.

**8.** Procédé selon la revendication 1 ou 2, dans lequel le au moins un précurseur contenant du silicium est choisi parmi le diéthoxyméthylsilane, le tétraéthoxysilane, le diméthyldiéthoxysilane, le diméthyldiméthoxysilane, le diméthyléthoxysilane, le triéthoxysilane, le triméthylphénoxysilane, le phénoxysilane, l'hexaméthyldisiloxane, le 1,1,2,2-tétraméthyldisiloxane, l'octaméthyltrisiloxane, le méthyltriéthoxysilane, le méthyltriacétoxysilane, le tétraacétoxysilane, le diméthylsilacyclobutane, l'octaméthylcyclotétrasiloxane, le 1,3,5,7-tétraméthylcyclotétrasiloxane, le méthylsilane, le diméthylsilane, le triméthylsilane, le tétraméthylsilane, les alcoxysilanes à pont méthylène et les combinaisons de ceux-ci.

**9.** Procédé selon la revendication 1 ou 2, dans lequel le au moins un précurseur porogène est choisi parmi l'alpha-terpinène, le limonène, le cyclohexane, le cyclooctane, le bicyclohexadiène, le gamma-terpinène, le camphène, le diméthylhexadiène, l'éthylbenzène, le norbonadiène, l'oxyde de cyclopentène, le 1,2,4-triméthylcyclohexane, le 1,5-diméthyl-1,5-cyclooctadiène, le camphène, l'adamantane, le 1,3-butadiène, les diènes substitués, le décahydronaphthélène, le toluène et les combinaisons de ceux-ci.

**10.** Procédé selon la revendication 1 ou 2, dans lequel le au moins un précurseur porogène comprend un hydrocarbure gazeux possédant de 1 à 13 atomes de carbone.

**11.** Procédé selon la revendication 1 ou 2, dans lequel le substrat est choisi parmi un circuit intégré, un écran plat et un écran flexible.

**12.** Procédé selon la revendication 1, le film organosillicate poreux obtenu comprenant : une constante diélectrique allant de 1,2 à 2,5 et un coefficient d'extinction du film mesuré à 240 nm par ellipsomètre allant de 0 à 0,03.

**13.** Procédé selon la revendication 12, le film organosilicate poreux obtenu comprenant des pores dont la taille moyenne est d'environ 100 nanomètres ou moins.

**14.** Procédé selon la revendication 12, dans lequel le coefficient d'extinction du film mesuré à des plages de 240 nm va de 0 à 0,025.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 61121666 A
- US 6312793 B
- WO 0002241 A
- WO 0207191 A2
- US 20060078676 A1
- US 7122880 B
- US 6818289 B
- US 6896955 B
- US 7265062 B
- US 6441491 B
- US 6479110 B
- US 7282458 B
- US 7288292 B
- US 7312524 B
- US 6846515 B
- US 7384471 B
- US 6171945 B
- US 6054206 A
- US 6054379 A
- US 6159871 A
- WO 9941423 A
- US 4770713 A

- US 5279771 A
- US 5419779 A
- US 5417877 A
- US 5597420 A
- US 5997658 A
- US 6677286 B
- US 6828289 B
- US 6943141 B
- US 6943142 B
- US 6951710 B
- US 20040063042 A
- US 20050119143 A
- US 20060014656 A
- US 20060016785 A
- US 20080199977 A
- US 20050196974 A
- US 20060003910 A
- US 20070299239 A
- US 6207555 B1
- US 6204201 B1
- US 6132814 A1

**Non-patent literature cited in the description**

- **S. CHATTOPADHYAY et al.** *Journal of Materials Science,* 2001, vol. 36, 4323-4330
- **G. KLOSTER et al.** *Proceedings of IITC,* 03 June 2002

- **OLIVER et al.** An improved technique for Determining Hardness and Elastic Modulus Using Load and Displacement Sensing Indentation Experiments. *J. Material Research,* 1992, vol. 7 (6), 1564-1583